# EUROPEAN PATENT SPECIFICATION

(11) **EP 2 774 260 B1**
(45) Date of publication and mention of the grant of the patent: **05.08.2015**
(21) Application number: 12769440.4
(22) Date of filing: 08.10.2012
(51) Int. Cl.: H02M 7/537, H03K 17/08, H05B 6/06

(54) **INDUCTION HEATING COOKER**
INDUKTIONSHERD
CUISEUR À INDUCTION

(30) Priority: 03.11.2011 TR 201110996
(43) Date of publication of application: 10.09.2014
(73) Proprietor: Arçelik Anonim Sirketi, 34950 Istanbul (TR)
(72) Inventor: YILMAZ, Namik, 34950 Istanbul (TR); OZTURK, Metin, 34950 Istanbul (TR); YARDIBI, Hakan Suleyman, 34950 Istanbul (TR)
(86) International application number: PCT/EP2012/069858
(87) International publication number: WO 2013/064333

(56) References cited:
- DE-A1-102005 020 805
- US-A- 5 986 484
- HIROTA I ET AL: "Performance evaluations of single-ended quasi-load resonant inverter incorporating advanced-2nd generation IGBT for soft switching", POWER ELECTRONICS AND MOTION CONTROL. SAN DIEGO, NOV. 9 - 13, 1992; [PROCEEDINGS OF THE INTERNATIONAL CONFERENCE ON INDUSTRIAL ELECTRONICS, CONTROL, INSTRUMENTATION AND AUTOMATION (IECON)], NEW YORK, IEEE, US, vol. CONF. 18, 9 November 1992 (1992-11-09), pages 223-228, XP010060719, DOI: 10.1109/IECON.1992.254629 ISBN: 978-0-7803-0582-3

## Description

The present invention relates to an induction heating cooker comprising electronic components that carry high current.

The induction heating cooker functions according to the principle of heating a cast iron or steel ferromagnetic cooking container with the magnetic field effect generated by the induction coil. In the state of the art, the half bridge series resonant (HBSR) circuits realized by using two power switches and two resonant capacitors, and the single switch quasi resonant (SSQR) circuits realized by one power switch and one resonant capacitor are used for driving a single induction coil. The single switch quasi resonant circuits (SSQR) are preferred due to cost advantage however they function in narrower energy frequency range and can deliver power to the cooking container only within a certain voltage and power range. Peak currents pass through the power switch (IGBT-Insulated Gate Bipolar Transistor) on the circuit board at the moment of vessel detection and at the moment of initial energizing. Besides vessel detection and initial energizing, when heating operation is desired to be performed at the low power level adjustment, that is called light-load, the resonant capacitor cannot be fully discharged and the power switch is subjected to peak currents when it starts conducting. The high amplitude peak currents result in the power switch to be damaged in a short time and the service life of the induction heating cooker decreases.

In the United States Patent Application No. US2010006563, an induction heating cooker according to the preamble of claim 1 and an operating method is explained.

In the article titled "Induction Cooking Systems with Single Switch Inverter Using New driving Techniques" published by the Zaragoza University, methods are proposed that relate to decreasing the high amplitude peak currents to which the power switch is subjected in the induction heating cooker.

The aim of the present invention is the realization of an inducting heating cooker wherein the power switch driving the parallel resonant circuit is prevented from damage by decreasing the high amplitude peak currents.

The induction heating cooker realized in order to attain the aim of the present invention, explicated in the first claim, comprises a parallel resonant circuit having an induction coil and a resonant capacitor connected in parallel to the induction coil, a power switch which drives the parallel resonant circuit, a collector, an emitter and a gate disposed on the power switch, a collector node whereto the collector is connected, a voltage measuring circuit that detects the resonant voltage on the collector node, a control unit that changes the power switch to the closed and the open positions depending on the resonant voltage value, a drive circuit that provides the power switch to be driven with the drive voltage, a gate-emitter capacitor connected between the gate and emitter terminals of the power switch, providing the power switch to pass from the open position to the closed position by being charged with the drive voltage, and an additional capacitor connected in parallel to the gate-emitter capacitor, the control unit providing the drive current value delivered from the drive circuit to the power switch to be changed by activating/deactivating the additional capacitor.

In an embodiment of the present invention, the induction heating cooker comprises a switch connected in series to the additional capacitor.

The control unit activates the additional capacitor by closing the switch at the moments of vessel detection and initial delivery of energy when peak currents act on the power switch, and the drive current value delivered to the power switch is decreased by increasing total capacitance value. By slowing down the power switch, the peak currents acting on the power switch are decreased.

The control unit deactivates the additional capacitor by opening the switch at the moments when the peak currents do not act on the power switch, and the drive current value delivered to the power switch is increased by decreasing the total capacitance value, thus the power switch is accelerated, and prevented from overheating.

In the induction heating cooker of the present invention, at the moments of vessel detection and delivery of initial energy at the start of vessel heating process, the power switch is provided to pass slowly from the open position to the closed position by decreasing the drive current value delivered to the power switch. The peak currents passing through the power switch are decreased and the power switch is prevented from being damaged. In the steady state when peak currents are not observed, the value of the drive current applied to the power switch is increased and overheating of the power switch is prevented.

The induction heating cooker realized in order to attain the aim of the present invention is illustrated in the attached figures, where:

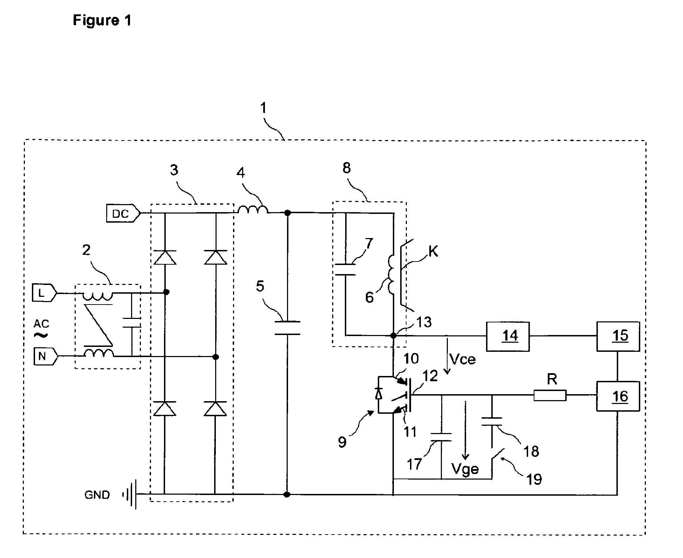

Figure 1 - is the schematic view of an induction heating cooker.

The elements illustrated in the figures are numbered as follows:
1. Induction heating cooker
2. Mains filtering circuit
3. Bridge rectifier
4. DC-line inductor
5. DC-line capacitor
6. Induction coil
7. Resonant capacitor
8. Parallel resonant circuit
9. Power switch
10. Collector
11. Emitter
12. Gate
13. Collector node
14. Voltage measuring circuit
15. Control unit
16. Drive circuit
17. Gate-emitter capacitor
18. Additional capacitor
19. Switch

The induction heating cooker (1) comprises a filtering circuit (2) that filters the AC mains voltage, a bridge rectifier (3) that converts the AC mains voltage into direct current, a DC-line inductor (4) and a DC-line capacitor (5) disposed at the output of the bridge rectifier (3) and which deliver DC voltage in a certain frequency range by filtering the voltage generated in the DC-line, a parallel resonant circuit (8) having an induction coil (6) that provides the vessel (K) placed thereon to be heated by the generated magnetic field and a resonant capacitor (7) connected in parallel to the induction coil (6), a power switch (9), for example an IGBT (Insulated Gate Bipolar Transistor), that drives the parallel resonant circuit (8), that is in conducting state in the closed position and provides the resonant capacitor (7) to be charged, providing the delivery of the energy stored in the resonant capacitor (7) to the vessel (K) by means of the induction coil (6) in the open position, a collector (10), an emitter (11) and a gate (12) disposed on the power switch (9), a collector node (13) whereto the collector (10) is connected, whereon resonant voltage (Vce) is generated in the open position of the power switch (9), a voltage measuring circuit (14) that detects the resonant voltage (Vce) on the collector node (13), a control unit (15), preferably a microcontroller, that determines the time the power switch (9) stays in the closed and open positions depending on the voltage value (Vce) of the collector node (13), a drive circuit (16) that provides the power switch (9) to be driven with the required level of drive voltage (Vge), disposed between the output of the control unit (15) and the gate (12), a resistor (R) disposed between the drive circuit (16) and the power switch (9) and a gate-emitter capacitor (17) connected between the gate (12) and emitter (11) terminals of the power switch (9), providing the power switch (9) to pass from the open position to the closed position by being charged with the drive voltage (Vge) applied through the drive circuit (16) and the resistor (R).

In the induction heating cooker (1), energy is stored in the induction coil (6) when the power switch (9) is in the closed position, and energy is delivered from the induction coil (6) to the vessel (K) in order to heat it when the power switch (9) is in the open position. When the induction heating cooker (1) is operated, a short term drive voltage (Vge), for example of 15V value in "pulse" form is applied to the gate (12) terminal of the power switch (9) by the control unit (15) by means of the drive circuit (16) for detecting the vessel (K), in the meantime the power switch (9) starts conducting by being changed to the closed position and the power switch (9) is subjected to high amplitude peak currents during the conducting time when it is closed. After the vessel (K) detection operation, the power switch (9) starts conducting for a while by being changed to the closed position at the start of the heating process, before delivery of initial energy to the vessel (K) and is subjected to high amplitude peak currents during the conducting time when it is closed. Furthermore, in the induction heating cooker (1), in the case of light-load wherein low power adjustment is made by the user, the power switch (9) is also subjected to high amplitude peak currents during the vessel (K) heating process in each of the closed positions it is changed to.

The induction heating cooker (1) of the present invention comprises an additional capacitor (18) connected in parallel to the gate-emitter capacitor (17).

The control unit (15) provides the capacitance value to be changed during the transmission between the drive circuit (16) and the power switch (9) by activating/deactivating the additional capacitor (18), the drive current (Ige) value delivered from the drive circuit (16) to the power switch (9) changes depending on the changing capacitance value and the passage time of the power switch (9) from the open position to the closed position where it starts conducting is provided to be decreased.

In an embodiment of the present invention, the induction heating cooker (1) comprises a switch (19) connected in series to the additional capacitor (18).

In this embodiment, the control unit (15) activates the additional capacitor (18) by closing the switch (19) at moments of vessel (K) detection, delivery of initial energy to the vessel (K) at the start of the heating process and in light-load conditions where peak currents act on the power switch (9). Since both of the gate-emitter capacitor (17) and the additional capacitor (18) are activated, the total capacitance value prior to the power switch (9) is increased, the drive current (Ige) value delivered from the drive circuit (16) to the power switch (9) is decreased and the passage time of the power switch (9) from the open position to the closed position where it starts conducting is increased. In other words, the power switch (9) is slowed down. The power switch (9) forms a resistance by itself against the high peak currents delivered as a result of the resonant capacitor (7) being discharged in the parallel resonant circuit (8) and the peak currents passing through the power switch (9) are decreased.

The control unit (15) deactivates the additional capacitor (18) by opening the switch (19) at steady state except for vessel (K) detection, delivery of initial energy to the vessel (K) at the start of the heating process and light-load conditions, where peak currents do not act on the power switch (9). Since only the gate-emitter capacitor (17) is activated in this situation, the total capacitance value prior to the power switch (9) decreases, the drive current (Ige) value delivered from the drive circuit (16) to the power switch (9) is increased and the passage time of the power switch (9) from the open position to the closed position where it starts conducting is decreased. In other words, the power switch (9) is accelerated. The power switch (9) is not forced to be continuously driven with low drive current (Ige) and the power switch (9) is prevented from overheating.

In the induction heating cooker (1), the power switch (9) is provided to be slowed down only at the moments when peak currents are observed by keeping the drive voltage (Vge) applied on the power switch (9) and decreasing the drive current (Ige). In the steady state where peak currents are not observed, the value of the drive current (Ige) applied to the power switch (9) is increased, the power switch (9) is accelerated, overheating of the power switch (9) is prevented.

It is to be understood that the present invention is not limited by the embodiments disclosed above and a person skilled in the art can easily introduce different embodiments. These should be considered within the scope of the protection disclosed by the claims of the present invention.

## Claims

1. An induction heating cooker (1) comprising a parallel resonant circuit (8) having an induction coil (6) and a resonant capacitor (7) connected in parallel to the induction coil (6), a power switch (9) which drives the parallel resonant circuit (8), a collector (10), an emitter (11) and a gate (12) disposed on the power switch (9), a collector node (13) whereto the collector (10) is connected, a voltage measuring circuit (14) that detects the resonant voltage (Vce) on the collector node (13), a control unit (15) that changes the power switch (9) to the closed and the open positions depending on the resonant voltage value (Vce), and a drive circuit (16) that provides the power switch (9) to be driven with the drive voltage (Vge), the induction heating cooker being **characterized in that** it further comprises a gate-emitter capacitor (17) connected between the gate (12) and emitter (11) terminals of the power switch (9), providing the power switch (9) to pass from the open position to the closed position by being charged with the drive voltage (Vge), and additional capacitor (18) connected in parallel to the gate-emitter capacitor (17), the control unit (15) according the drive current (Ige) value delivered from the drive circuit (16) to the power switch (9) to be changed by activating/deactivating the additional capacitor (18).

2. An induction heating cooker (1) as in Claim 1, **characterized in that** a switch (19) is connected in series to the additional capacitor (18).

3. An induction heating cooker (1) as in Claim 2, **characterized in that** the control unit (15) activates the additional capacitor (18) by closing the switch (19) at moments when peak currents act on the power switch (9) and decreases the drive current (Ige) value delivered to the power switch (9).

4. An induction heating cooker (1) as in Claim 2 and 3, **characterized in that** the control unit (15) deactivates the additional capacitor (18) by opening the switch (19) at moments when peak currents do not act on the power switch (9) and increases the drive current (Ige) value delivered to the power switch (9).

## Patentansprüche

1. Induktionsherd (1), **umfassend** eine Parallelresonanzschaltung (8) mit einer Induktionsspule (6) und einen Resonanzkondensator (7), der parallel mit der Induktionsspule (6) geschaltet ist, einen Leistungsschalter (9), der die Parallelresonanzschaltung (8) antreibt, einen Kollektor (10), einen Emitter (11) und ein Gate (12), die am Leistungsschalter (9) angeordnet sind, einen Kollektorknoten (13), mit dem der Kollektor (10) verbunden ist, eine Spannungsmessschaltung (14), die die Resonanzspannung (Vce) am Kollektorknoten (13) misst, eine Steuereinheit (15), die den Leistungsschalter (9) abhängig vom Resonanzspannungswert (Vce) in die geschlossene und die offene Stellung umschaltet, und eine Antriebsschaltung (16), die dafür sorgt, dass der Leistungsschalter (9) mit der Antriebsspannung (Vge) angetrieben wird, wobei der Induktionsherd (1) **dadurch gekennzeichnet ist, dass** er ferner einen Gate-Emitter-Kondensator (17), der zwischen dem Gate- (12) und dem Emitteranschluss (11) des Leistungsschalters (9) verbunden ist und dafür sorgt, dass der Leistungsschalter (9) von der offenen Stellung in die geschlossene Stellung übergeht, indem er mit der Antriebsspannung (Vge) aufgeladen wird, und einen weiteren Kondensator (18) umfasst, der parallel mit dem Gate-Emitter-Kondensator (17), wobei die Steuereinheit (15) dafür sorgt, dass der Wert des Antriebsstroms (Ige), der von der Antriebsschaltung (16) an den Leistungsschalter (9) bereitgestellt wird, durch Aktivieren/Deaktivieren des weiteren Kondensators (18) geändert wird.

2. Induktionsherd (1) nach Anspruch 1, **dadurch gekennzeichnet, dass** ein Schalter (19) mit dem zusätzlichen Kondensator (18) in Reihe geschaltet ist.

3. Induktionsherd (1) nach Anspruch 2, **dadurch gekennzeichnet, dass** die Steuereinheit (15) den weiteren Kondensator (18) aktiviert, indem sie den Schalter (19) in Augenblicken schließt, wenn Spitzenströme am Leistungsschalter (9) anliegen, und den Wert des Antriebsstroms (Ige) senkt, der an den Leistungsschalter (9) bereitgestellt wird.

4. Induktionsherd (1) nach Anspruch 2 und 3, **dadurch gekennzeichnet, dass** die Steuereinheit (15) den weiteren Kondensator (18) deaktiviert, indem sie den Schalter (19) in Augenblicken öffnet, wenn keine Spitzenströme am Leistungsschalter (9) anliegen, und den Wert des Antriebsstroms (Ige) erhöht, der an den Leistungsschalter (9) bereitgestellt wird.

## Revendications

1. Un dispositif de chauffage à induction (1) **comprenant** un circuit parallèle de résonance (8) présentant une bobine d'induction (6) et un condensateur de résonance (7) relié en parallèle à la bobine d'induction (6), un interrupteur d'alimentation (9) qui entraîne le circuit parallèle de résonance (8), un collecteur (10), un émetteur (11) et une grille (12) disposés sur l'interrupteur d'alimentation (9), un noeud collecteur (13) auquel le collecteur (10) est relié, une unité de mesure de tension (14) qui détecte la tension de résonance (Vce) sur le noeud collecteur (13), une unité de commande (15) qui change l'interrupteur d'alimentation (9) entre les positions fermée et ouverte en fonction de la valeur de la tension de résonance (Vce), et un circuit d'entraînement (16) qui permet l'entraînement de l'interrupteur d'alimentation (9) avec la tension d'entraînement (Vge), le dispositif de chauffage à induction (1) étant **caractérisé en ce qu'**il comprend en outre un condensateur grill-émetteur (17) qui est relié entre la grille (12) et l'émetteur (11) de l'interrupteur d'alimentation (9), qui permet à l'interrupteur d'alimentation (9) de passer de la position ouverte à la position fermée en étant chargé par la tension d'entraînement (Vge), et un condensateur supplémentaire (18) relié en parallèle au condensateur grill-émetteur (17), l'unité de commande (15) permettant le changement de la valeur du courant d'entraînement (Ige) fourni du circuit d'entraînement (16) à l'interrupteur d'alimentation (9) par l'activation/désactivation du condensateur supplémentaire (18).

2. Un dispositif de chauffage à induction (1) selon la Revendication 1, **caractérisé en ce qu'**un interrupteur (19) est relié en série avec le condensateur supplémentaire (18).

3. Un dispositif de chauffage à induction (1) selon la Revendication 2, **caractérisé par** l'unité de commande (15) désactive le condensateur supplémentaire (18) en fermant l'interrupteur (19) à des moments où des courants de crête agissent sur l'interrupteur d'alimentation (9), et diminue la valeur du courant d'entraînement (Ige) délivré à l'interrupteur d'alimentation (9).

4. Un dispositif de chauffage à induction (1) selon la Revendication 2 et 3, **caractérisé par** l'unité de commande (15) désactive le condensateur supplémentaire (18) en s'ouvrant l'interrupteur (19) à des moments où des courants de crête n'agissent pas sur l'interrupteur d'alimentation (9), et augmente la valeur du courant d'entraînement (Ige) délivré à l'interrupteur d'alimentation (9).
